# EUROPÄISCHE PATENTANMELDUNG

(11) **EP 2 204 471 A2**
(43) Veröffentlichungstag der Anmeldung: **07.07.2010**
(21) Anmeldenummer: 09180652.1
(22) Anmeldetag: 23.12.2009
(51) Int. Cl.: C23C 16/18, C23C 16/46, C23C 10/50

(54) **Verfahren zur Beschichtung von temperatur- und/oder heißmedienbeaufschlagten Substraten sowie heißmedien- und/oder temperaturbeaufschlagtes Substrat**

(30) Priorität: 23.12.2008 DE 102008055147
(71) Anmelder: Eisenwerk Erla GmbH, 08340 Schwarzenberg/OT Erla (DE); InnCoa GmbH, 93333 Neustadt/Donau (DE)
(72) Erfinder: Hahn, Dietmar, 08359, Breitenbrunn OT Antonsthal (DE); Dr.-Ing. Heller, Jörg, 51776, Engelskirchen (DE); Oberhauser, Simon, 85296, Rohrbach (DE)
(74) Vertreter: Schlief, Thomas P.

(57) **Zusammenfassung**

Bei einem Verfahren zur Beschichtung von im Betrieb oder beim Herstellungsprozess wärmebeaufschlagten Substraten oder Substraten mit vorhandener Kernwärme mit einer metallischen Oberfläche wird auf die metallische Oberfläche wenigstens eine metallische Schicht aufgebracht. Zwischen der Oberfläche und der wenigstens einen Schicht wird eine Legierungsschicht durch Interdiffusion erzeugt. Nach dem Aufbringen der wenigstens einen Schicht wird das Substrat an seinem Einsatzort montiert und in Betrieb genommen oder die wenigstens eine Schicht wird vor und/oder während und/oder nach dem Herstellprozess aufgebracht. Die Legierungsschicht wird durch die Prozesswärme im Betrieb und/oder die Prozesswärme des Herstellprozesses erzeugt. Bei einem heißgas- und/oder heißmedien- und/oder temperatur- und/oder atmosphärisch beaufschlagten Bauteil ist eine Legierungsschicht durch die Prozesswärme des Herstellprozesses oder die Prozesswärme im Betrieb erzeugt.

## Beschreibung

Die vorliegende Erfindung betrifft ein Verfahren zur Beschichtung von im Betrieb oder beim Herstellprozess wärmebeaufschlagten Substraten oder Substraten mit vorhandener Kernwärme mit einer metallischen Oberfläche. Auf die metallische Oberfläche wird wenigstens eine metallische Schicht aufgebracht und zwischen der Oberfläche und der wenigstens einen Schicht eine Legierungsschicht durch Interdiffusion erzeugt.

Im Stand der Technik sind verschiedenste Verfahren zum Aufbringen von Schichten auf verschiedene Oberflächen bekannt, welche die entsprechenden Bauteile gegen Abrieberosion und Korrosion schützen sollen. Insbesondere bei im Betrieb heißgasbeaufschlagten Bauteilen müssen hierbei je nach Werkstoff Schutzmaßnahmen gegen Verzunderung getroffen werden, da es ansonsten im Betrieb zu Ablösungen der Zunderschichten kommen kann, was zur Zerstörung von Bauteilen führen kann. Hierzu sind beispielsweise Deckschichten aus Aluminiumoxid, Chromoxid oder Siliziumoxid bekannt. Ebenso sind insbesondere bei Turbinenbauteilen keramische Schichten bekannt. Um die Haftung von Beschichtungen auf dem Substrat zu verbessern und besonders widerstandsfähige Legierungsschichten aus dem Substrat und dem Beschichtungsmaterial zu erzeugen, ist es weiterhin bekannt, Bauteile nach dem Beschichten einer Wärmebehandlung zu unterziehen.

Ein bekanntes Verfahren zur Beschichtung von Substraten ist das PackZementierverfahren, bei welchem die Oberfläche des Bauteiles einem Pulver ausgesetzt wird. Die US 3,667,985 beschreibt beispielsweise ein derartiges Verfahren, wobei das Pulver Ti₂AlC einen inerten Füllstoff sowie einen Aktivator enthält. Während der Packzementierungsbeschichtung wird das Substrat für eine bestimmte Zeit einer erhöhten Temperatur ausgesetzt, so dass eine Aluminidbildung durch Diffusion stattfinden kann. Die Packzementierverfahren finden bei einer Temperatur von etwa 1000 °C statt, so dass diese nicht für alle Bauteile und Werkstoffe geeignet sind. Zum Überziehen innerer Hohlräume ist das Packzementierverfahren weniger geeignet. Zudem sind die bei der Einsatzzementierung verwendeten Pulvermaterialien häufig schwierig zu entfernen.

Die DE 10 2004 046 112 A1 beschreibt ein CVD-Verfahren zum Bilden einer Diffusionsaluminidbeschichtung auf einem Substrat, bei welchem das Substrat auf eine Temperatur von 900°C bis 1.200°C erhitzt wird und die Beschichtung in einer Beschichtungskammer bei dieser Temperatur erfolgt. Durch die Höhe der Beschichtungstemperatur entsteht eine Aluminiddiffusionsbeschichtung während des Beschichtungsvorganges. Es kann jedoch durch die Beschichtungstemperatur zu Verformungen der Bauteile sowie zu unerwünschten Prozessen in den Substraten kommen, welche Festigkeit und Lebensdauer beeinträchtigen können.

Die DE 26 45 931 A1 beschreibt ein Verfahren zum Beschichten eines Bauteiles, welches auch zur Beschichtung von Hohlräumen geeignet sein soll. Hierbei wird das Substrat während des Beschichtungsvorganges auf eine Temperatur von etwa 100-450 °C erhitzt, welche zur thermischen Zersetzung einer metallorganischen Verbindung führt, wodurch ein Metallniederschlag auf der Oberfläche erzeugt wird. Als Beschichtungsmaterialen werden hier Aluminium, Chrom, Nickel und deren Legierungen genannt. Anschließend wird der Überzug auf eine zweite Temperatur erhitzt, um flüchtige Materialien aus der aufgebrachten Schicht zu entfernen und schließlich wird die Temperatur der Oberfläche und der Schicht auf eine Temperatur zwischen 870°C bis 1.100°C erhitzt und auf dieser Temperatur gehalten, um die Schicht und die Oberfläche des Bauteiles zu interdiffundieren. Die Abscheidung der Schicht wird somit bei vergleichsweise niedriger Temperatur durchgeführt. Anschließend ist jedoch ein weiterer Verfahrensschritt erforderlich, in welchem das Substrat wiederum auf eine sehr hohe Temperatur erhitzt wird, um die Legierungsschicht auszubilden. Die anschließende Wärmebehandlung ist einerseits sehr aufwändig und kann andererseits wiederum zu einem Verzug des Bauteiles führen, so dass dieses in Folge häufig überarbeitet werden muss, um die gewünschten Maße einzuhalten. Ferner kann die Wärmebehandlung zu einer negativen Gefügeveränderung hinsichtlich der Bildung von Grobkorn oder Festigkeitsverlust der Struktur führen.

Aufgabe der vorliegenden Erfindung ist es daher, ein Verfahren zur Beschichtung von Substraten, bei welchem eine Legierungsschicht durch Interdiffusion erzeugt wird, zu vereinfachen.

Die Aufgabe wird gelöst durch die Merkmale des Anspruches 1.

Bei einem Verfahren zur Beschichtung von im Betrieb oder beim Herstellprozess wärmebeaufschlagten Substraten oder Substraten mit vorhandener Kernwärme Substraten mit einer metallischen Oberfläche wird auf die metallische Oberfläche wenigstens eine metallische Schicht aufgebracht. Zwischen der Oberfläche und der wenigstens einen Schicht wird eine Legierungsschicht durch Interdiffusion erzeugt. Erfindungsgemäß wird die Legierungsschicht während des ersten Einsatzes oder der ersten Einsätze des Substrates durch die Prozesswärme des an seinem Einsatzort montierten Bauteils bzw. Substrats im Betrieb erzeugt oder aber das Substrat wird bereits vor und/oder während und/oder kurz nach dem Herstellprozess beschichtet und die Legierungsschicht durch die Prozesswärme des Herstellprozesses bzw. die Kernwärme des Substrates erzeugt. Unter einem Substrat wird im Rahmen der vorliegenden Erfindung ein beliebiges Bauteil, Werkstück, Vormaterial oder Halbzeug verstanden, welches sowohl als Stückmaterial oder auch als Endlosmaterial vorliegen kann. Es kann sich hierbei um ein im Betrieb heißgas- und/oder heißmedien- und/oder temperaturbeaufschlagtes Bauteil handeln. Das Substrat kann aber auch ein durch seinen Herstellprozess heißgas- und/oder heißmedien- und/oder temperaturbeaufschlagt und/oder atmosphärisch beaufschlagt sein. Wesentlich für die vorliegende Erfindung ist es, dass Herstellung und/oder Inbetriebnahme des Substrats mit der Beschichtung derart abgestimmt wird, dass die Bildung der Legierungsschicht durch die Prozesswärme wie beschrieben erfolgt. Unter einer Legierung werden im Rahmen der vorliegenden Erfindung Mischkristalle, intermetallische Phasen, Mischungen von Metallen sowie sämtliche Kombinationen dieser Ausprägungen verstanden.

Nach einer ersten Ausführung der Erfindung wird die metallische Schicht nach dem Herstellungsprozess des Substrates auf die noch heiße Oberfläche des Substrates aufgebracht. Das Substrat kann beispielsweise ein Gussstück oder auch ein beliebiges heißumgeformtes Bauteil sein.

Ebenso ist es vorteilhaft, wenn die metallische Schicht bereits während des Herstellungsprozesses des Substrates aufgebracht wird und die Legierungsschicht simultan erzeugt wird. Das Substrat kann in diesem Falle beispielsweise ein Walzmaterial, ein Strangpresserzeugnis oder ein durch einen anderen Warmumformprozess hergestelltes Material sein. Wird die Beschichtung vor einem Warmumformprozess aufgebracht, kann die Legierungsschicht während der Warmumformung ausgebildet werden. Besonders vorteilhaft ist es hierbei, dass die aufgebrachte Beschichtung das Substrat vor einer Verzunderung schützt. Eine aufwändige Nachbearbeitung verzunderter Bauteile kann somit vermieden werden.

Handelt es sich bei dem Substrat um ein Endlosmaterial, so ist es besonderes vorteilhaft, wenn die Beschichtung und die Ausbildung der Legierungsschicht bereits während der Herstellung erfolgt. Die Beschichtung kann dann kontinuierlich in einem Durchlaufverfahren aufgebracht werden. Beispielsweise kann die metallische Schicht durch Spritzen auf die heiße Oberfläche des durchlaufenden Substrats kontinuierlich aufgebracht werden.

Die Erfindung kann jedoch ebenso vorteilhaft in Verbindung mit einem diskontinuierlichen Herstellprozess eingesetzt werden. So kann die metallische Schicht diskontinuierlich auf ein Stückmaterial oder auch einen Teil eines Endlosmaterials aufgebracht werden und das beschichtete Substrat anschließend ggf. abgelängt und einem Umformprozess unterzogen werden. Handelt es sich um einen Warmumformprozess, so kann die Legierungsschicht ohne zusätzliche Wärmebehandlung unter Nutzung der Kernwärme während des Umformprozesses ausgebildet werden.

Nach einer anderen Ausführung der Erfindung wird nach dem Aufbringen der wenigstens einen Schicht auf ein im Betrieb heißgas- und/oder heißmedien-und/oder temperaturbeaufschlagtes und/oder kernwärmebeinhaltendes Bauteil das Bauteil an seinen Einsatzort montiert und in Betrieb genommen und die Legierungsschicht wird während des ersten Einsatzes oder der ersten Einsätze des Bauteiles durch die Prozesswärme im Betrieb erzeugt.

Es hat sich gezeigt, dass es möglich ist, bei den genannten Bauteilen die besonders widerstandsfähige Legierungsschicht statt wie im Stand der Technik durch eine gezielte Wärmebehandlung über eine definierte Zeitdauer auch ausschließlich durch die Prozesswärme im Betrieb des Bauteiles zu erzeugen. Es hat sich nämlich herausgestellt, dass trotz der im Einsatz des Bauteiles nicht regelbaren Prozesstemperatur sowie der unterschiedlichen Zeitdauer des ersten Einsatzes oder der ersten Einsätze eine definierte Legierungsschicht erzeugt werden kann. Nach einer gewissen Zeit stellt sich hierbei von selbst ein stabiler Zustand ein, so dass die Legierungsbildung abgeschlossen ist. Somit ist es möglich, thermische Überlastungen des Bauteiles oder einzelner Strukturen des Bauteiles zu vermeiden, da diese lediglich auf die Temperatur erhitzt werden, welche sie im Betrieb ohnehin erreichen. Auch werden nur die im Betrieb tatsächlich mit dem Heißmedium beaufschlagten Strukturen des Bauteiles mit der für die Bildung der Legierungsschicht erforderlichen Temperatur beaufschlagt. Eine negative Gefügebeeinflussung am Substrat oder an einzelnen Strukturen kann somit vermieden werden. Im Gegensatz hierzu war es im Stand der Technik nachteilig, dass zur Bildung einer Legierungsschicht das gesamte Substrat auf eine entsprechende Temperatur erhitzt werden musste, so dass weniger temperaturfeste Strukturen zu hohen Temperaturen und damit Beschädigungen ausgesetzt werden konnten. Auch ein Verziehen des Bauteiles und eine gegebenenfalls anschließende erneute Überarbeitung können vermieden werden, da eine Verformung des Bauteiles allenfalls im Verbund mit der gesamten Baugruppe stattfindet, so dass es hierdurch nicht zu Passproblemen oder Dichtigkeitsproblemen kommen kann. Ein erfindungsgemäßes Bauteil, welches nach dem genannten Verfahren hergestellt ist, weist somit eine funktional ausreichend dicke Legierungsschicht auf und ist dennoch vergleichsweise einfach und kostengünstig herstellbar.

Während des ersten Einsatzes bzw. der ersten Einsätze wird ein ausreichender Schutz des Bauteiles durch die aufgebrachte metallische Beschichtung erzielt. Diese allein ist ausreichend, das Bauteil während der ersten Einsätze zu schützen, bis schließlich die widerstandsfähige und schützende Legierungsschicht erzeugt ist, welche das Bauteil im Dauerbetrieb sowie bei höheren Belastungen schützt. Da der Verfahrensschritt der Diffusionsbehandlung eingespart werden kann, kann das erfindungsgemäße Verfahren im Vergleich zum Stand der Technik sehr kostengünstig, energiesparend und bauteilschonend durchgeführt werden. Zudem können häufig auch Materialien verwendet werden, welche an sich nicht für den gewünschten Einsatz geeignet wären.

Nach einer ersten Ausführungsform der Erfindung wird die Legierungsschicht nahezu vollständig nach Montage des Bauteiles während des oder der ersten Einsatzes/Einsätze erzeugt. Hierbei wird zunächst eine metallische, vorzugsweise eine reinmetallische Schicht bei niedriger Beschichtungstemperatur von beispielsweise unter 350°C abgeschieden, welche das Bauteil während des Ersteinsatzes bzw. der ersten Einsätze schützt, bis eine funktional ausreichende Legierungsschicht ausgebildet ist. Die Beschichtung kann hierbei beispielsweise in einem MOCVD-Verfahren aufgebracht werden.

Ebenso ist es jedoch auch möglich, dass die Legierungsschicht zumindest teilweise bereits während des Beschichtungsvorganges erzeugt wird. Je nach verwendetem Beschichtungsverfahren sowie nach Abscheidetemperatur findet eine verfahrensbedingte Diffusion bereits während des Beschichtungsvorganges statt. Die Ausbildung einer funktionalen Legierungsschicht, welche in der Lage ist, das Bauteil zu schützen, findet jedoch auch hier im Wesentlichen erst nach der Montage des Bauteiles am Einsatzort statt.

Wird hingegen ein Beschichtungsverfahren mit vergleichsweise hoher Abscheidetemperatur gewählt, wie beispielsweise das Packzementieren, so kann auch bereits während des Beschichtungsvorganges eine messbare Legierungsschicht erzeugt werden. Ebenso ist es möglich, zwei oder mehrere Beschichtungsmaterialien zugleich oder unmittelbar hintereinander aufzubringen, wodurch es ebenfalls bereits während des Beschichtungsvorganges zu einer nennenswerten Diffusion und Ausbildung einer messbaren Legierungsschicht kommen kann. Eine gezielte Steuerung der Prozessparameter im Hinblick auf die Diffusion ist hierbei jedoch nicht erforderlich, da die vollständige Ausbildung bzw. Fertigstellung der Legierungsschicht erst nach Montage des Bauteiles am Einsatzort erfolgt.

Um die Legierungsschicht durch die Prozesswärme im Betrieb ausbilden zu können, ist es vorteilhaft, wenn das Substrat im Betrieb eine Prozesstemperatur von mindestens 450°C, vorzugsweise mindestens 550°C, erreicht. Besonders vorteilhaft ist es, wenn die Prozesstemperatur bereits während des Ersteinsatzes über einen ausreichenden Zeitraum erreicht wird, so dass die Legierungsschicht bereits vollständig während des Ersteinsatzes ausgebildet wird. Ebenso ist es jedoch auch möglich, dass sich die Fertigstellung der Legierungsschicht abhängig von der Dauer der Einsätze und der hierbei jeweils erreichten Temperaturen über mehrere Einsätze erstreckt. Die Prozesstemperatur des Bauteiles kann hierbei sowohl durch Wärmeübertragung durch angrenzende Bauteile wie auch durch Heißgase oder Heißmedien erreicht werden, welchen das Substrat ausgesetzt ist.

Nach einer besonders vorteilhaften Ausführung der Erfindung wird eine metallische Schicht aus Aluminium, Titan, Silizium, Nickel, Nickelaluminium, Nickelverbindungen oder Chrom aufgebracht. Vorzugsweise wird die metallische Schicht in einem MOCVD-Verfahren aufgebracht, da dies sehr hohe Abscheideraten und niedrige Abscheidetemperaturen ermöglicht.

Vorzugsweise wird wenigstens eine Schicht in einem Niedertemperatur-MOCVD-Verfahren unter inerter Atmosphäre aufgebracht. Ein derartiges Verfahren ist beispielsweise in der WO 2005/028704 A1 beschrieben, auf welche bzgl. der Niedertemperatur-MOCVD-Beschichtung Bezug genommen wird. Hierbei wird das zu beschichtende Substrat in einem Reaktor angeordnet und auf eine bestimmte Temperatur aufgeheizt, welche höher liegt als die Zersetzungstemperatur eines das Beschichtungsmetall enthaltenden Precursorgases. Das Precursorgas wird in den Reaktor eingeleitet und zersetzt sich thermisch auf der Substratoberfläche, so dass diese mit dem Metall überzogen wird. In Abhängigkeit von der Zeitdauer sowie der Menge des eingeleiteten Gases ist hierbei die Schichtdicke bestimmbar.

Eine besonders vorteilhafte Ausführungsform der Erfindung sieht vor, dass eine reinmetallische Aluminiumschicht auf die metallische Oberfläche des Bauteiles aufgebracht wird und als Legierungsschicht eine Aluminidschicht erzeugt wird. Ein entsprechendes heißmedien- oder heißgas- oder temperaturbeaufschlagtes Substrat weist auf seiner metallischen Oberfläche eine Aluminiumschicht auf, wobei eine Legierungsschicht aus Aluminiden zwischen der Oberfläche und der Aluminiumschicht angeordnet ist. Derartige Aluminidschichten weisen eine besonders hohe Korrosionsbeständigkeit insbesondere gegen Heißgaskorrosion, Heißgasoxidation, Metalldusting, Sulfidierung, Schutz gegen Ammoniak und dessen Zersetzungsprodukte bzw. Stickstoffverbindungen, Chlorverbindungen und allgemein gegen heiße Abgase aus Verbrennungsprozessen auf. Ebenso kann als Legierungsschicht auch eine Aluminium-Nickelverbindung erzeugt werden.

Nach einer ersten Ausführung der Erfindung wird die metallische oder reinmetallische Schicht direkt auf die Oberfläche des Substrats aufgebracht, wobei das Substrat aus einem Eisenwerkstoff, vorzugsweise einem Eisenwerkstoff mit einem hohen Nickelgehalt, besteht. Wird beispielsweise eine reine Aluminiumschicht auf ein Eisensubstrat aufgebracht, so entsteht nach der Montage des Bauteiles an seinem Einbauort und der Inbetriebnahme des Bauteiles eine Legierungsschicht mit Eisenaluminiden aus der reinen Aluminiumschicht und dem Eisensubstrat. Das Substrat kann jedoch auch ein Eisenwerkstoff mit einem hohen Nickelanteil sein, wobei eine Legierungsschicht mit Nickelaluminiden entsteht, welche im Vergleich zu einer Schicht mit Eisenaluminiden duktiler und weicher ist. Andere Substratwerkstoffe, beispielsweise Stahlwerkstoffe wie unlegierte oder niedrig legierte Stähle, hochlegierte Stähle oder Chromstahl sind ebenfalls denkbar.

Nach einer anderen Ausführung der Erfindung wird vor dem Aufbringen der metallischen Schicht eine Zwischenschicht, vorzugsweise eine homogene Nickelschicht oder eine Schicht aus Nickelverbindungen, als metallische Oberfläche des Substrats aufgebracht. Als Nickelverbindungen können beispielsweise NiW, NiMo, Ni-Co, Ni-P, Ni-B und andere aufgebracht werden. Hierdurch können auch Werkstoffe mit einem geringeren Nickelanteil verwendet werden und dennoch eine Nickelaluminidschicht erzeugt werden. Ein derartige Schicht schützt durch ihre Duktilität das Substrat besonders gut vor einem Eindringen von Sauerstoff in das Grundmaterial. Eine derartige Nickelschicht kann in jedem beliebigen Verfahren, beispielsweise galvanisch, chemisch oder auch physikalisch, aufgebracht werden. Die metallische Oberfläche des Substrats, auf welche die metallische Schicht aufgebracht wird, ist somit durch die Nickelschicht gebildet. Beschichtungssysteme mit anderen Metallen als Aluminium und Nickel sind jedoch ebenfalls denkbar. Die nach der Montage des Substrats an den Einsatzort erzeugte Aluminidschicht weist vorzugsweise eine Schichtdicke von 15 µm bis 100 µm auf, um eine gute Korrosionsbeständigkeit zu erzielen.

Vorteilhaft beim Aufbringen einer reinmetallischen Aluminiumschicht ist es, dass aus dem Aluminium aus der Legierungsschicht eine schützende Aluminiumoxiddeckschicht an der Oberfläche gebildet wird. Die Schichtstärke der Aluminiumoxiddeckschicht beträgt ca. 1µm. Diese ist bei eventuellen Beschädigungen aus dem Aluminium der Aluminiumlegierungsschicht regenerierbar. Die Korrosionsbeständigkeit der Bauteile kann somit gegenüber dem unbeschichteten Werkstoff sehr stark erhöht werden. So kann bei einigen Eisengusswerkstoffen eine Oxidationsbeständigkeit erzielt werden, welche mit der von chromhaltigem Stahlguss vergleichbar ist. Weiterhin ist es hierdurch auch möglich, niedrig legierte Materialien wie niedernickelhaltige Gusseisen anstelle von Stahlguss oder hochlegiertes Gusseisen, wie hochnickelhaltige Gusseisen (Ni-Anteil > 20%) auch für Hochtemperaturanwendungen zu verwenden. Ebenso ist es je nach Verwendungszweck möglich, verschiedene Stahlwerkstoffe, beispielsweise unlegierten Stahl, niedrig legierten Stahl und hoch legierten Stahl oder auch Chromstahl zu verwenden.

Ein Bauteil, welches nach dem erfindungsgemäßen Verfahren beschichtet ist, kann jedoch auch aus beliebigen Eisenwerkstoffen wie Eisenbasiswerkstoffen, Eisengusswerkstoffen oder auch anderen metallischen Werkstoffen, wie beispielsweise Titan oder Titanlegierungen oder auch Cobalt-Basiswerkstoffen, bestehen. Als für Hochtemperaturanwendungen geeignete Gusswerkstoffe kommen wie bereits erwähnt niedriglegierte Gusseisen (Ni-Anteil < 1%), verschiedene Ni-Resistwerkstoffe, wie beispielsweise mittellegierte Gusseisen (Ni-Anteil ≤ 20%) oder hochlegierte Gusseisen (Ni-Anteil > 20%) oder auch Grauguss mit Kugelgraphit (GJS) in Frage.

Vorteilhaft ist es, wenn das Substrat aus einem Werkstoff mit einem hohen Nickelgehalt von vorzugsweise 10% besteht. Besonders bevorzugt besteht das Substrat aus einem Werkstoff mit einem Nickelgehalt von über 20%. Bei einem Werkstoff mit einem hohen Nickelgehalt kann eine Aluminiumschicht direkt auf das Substrat aufgebracht werden, wobei eine Legierungsschicht mit Ni-ckelaluminiden erzeugt wird. Ebenso ist es jedoch auch möglich, vor dem Aufbringen der Aluminiumschicht das Substrat mit einem anderen Material zu beschichten oder eine zusätzliche Nickelschicht aufzubringen.

Die vorgenannten Ausführungen beschreiben das Aufbringen einer rein metallischen Aluminiumschicht mit dem Vorteil der Bildung einer schützenden Aluminiumoxiddeckschicht. Anstelle einer rein metallischen Aluminiumschicht kann jedoch auch eine rein metallische Schicht aus Silizium oder Chrom auf ein für Hochtemperaturanwendungen geeignetes Substrat aufgebracht werden, sofern keine geschlossene stabile Oxiddeckschicht erforderlich ist. Ebenso ist es möglich, eine Nickelaluminiumschicht beispielsweise auch durch Flammspritzen aufzubringen. Eine derartige Nickel- und Aluminiumschicht kann jedoch auch ebenso in einem MOCVD-Verfahren aufgebracht werden.

Eine besonders vorteilhafte Weiterbildung der Erfindung sieht vor, dass die wenigstens eine Schicht auf eine innere Oberfläche eines heißmedienführenden Bauteiles aufgebracht wird. Eine derartige Innenbeschichtung kann nur mittels eines CVD-Verfahrens aufgebracht werden, da bei anderen Verfahren durch die gerichtete Aufbringung der Schicht kein gleichmäßiger Auftrag erzielbar ist. Das erfindungsgemäße Verfahren entfaltet entsprechend besondere Vorteile bei der Innenbeschichtung heißmedienführender Bauteile, da diese in einem MOCVD-Verfahren bei niedriger Temperatur beschichtet werden können. Durch die Abscheidung bei niedriger Temperatur ist weder eine Wärmebehandlung zur Gefügewiederherstellung noch eine Diffusionsbehandlung vor Montage bzw. Ersteinsatz des Bauteils notwendig. Als Bauteile sind beispielsweise Kühler, Heizelemente und dgl. denkbar.

Besonders vorteilhaft ist es, wenn die wenigstens eine Schicht auf eine innere und/oder äußere Oberfläche eines heißgasbeaufschlagten Bauteiles einer Brennkraftmaschine aufgebracht wird. Hierbei können die für die vollständige Ausbildung der Legierungsschicht erforderlichen Temperaturen häufig bereits beim Erstbetrieb der Brennkraftmaschine erreicht werden, so dass das Bauteil nach dem Erstbetrieb gegen Heißgaskorrosion gut geschützt ist. Denkbar sind hierbei Turbinenschaufeln oder auch andere Turbinenteile, welche Heißgasen ausgesetzt sind, oder auch Abgaskrümmer, Turbolader, Abgasleitungen, heißgasbeaufschlagte Ventile oder auch Diffusoren.

Besonders vorteilhaft ist es, wenn zur Innenbeschichtung des Substrats ein Precursorgas direkt in den Innenraum des Substrats geleitet wird. Im Stand der Technik wird hingegen das zu beschichtende Substrat bzw. die zu beschichtenden Bauteile in einem Beschichtungsreaktor angeordnet und der Beschichtungsreaktor wird mit einem Precursorgas beaufschlagt, wobei das Precursorgas auch das Substrat durchströmt. Wird hingegen ein Precursorgas ausschließlich direkt in den Innenraum des Substrats geleitet, so bildet das Substrat selbst den Beschichtungsreaktor, wodurch das Beschichtungsverfahren weiter vereinfacht werden kann. Beispielsweise wird das auf seiner inneren Oberfläche zu beschichtende Bauteil, wie an sich auch in der WO 2005/028704 A1 beschrieben, auf eine Temperatur gebracht, welche etwas höher liegt als die Zersetzungstemperatur des Precursorgases. Anschließend wird beispielsweise ein Precursorgas durch das zu beschichtende temperierte Substrat hindurchgeleitet. Je nach Ausführung des Substrats ist es möglich, zugleich eine Außenbeschichtung weiterer Bauteile vorzunehmen, welche in dem Innenraum des Substrats angeordnet sind.

Ebenso ist jedoch auch möglich, das Substrat in einem Reaktor zu beschichten, wobei zugleich eine Außenbeschichtung weiterer Bauteile erfolgt.

Eine vorteilhafte Weiterbildung des Verfahrens sieht vor, dass das Substrat nur partiell in ausgewählten Strukturen beschichtet wird. Hierdurch kann die Beschichtung ebenfalls sehr wirtschaftlich aufgebracht werden.

Besonders vorteilhaft bei dem erfindungsgemäßen Verfahren ist es weiterhin, dass durch gezielte Anströmung einzelner Bereiche ausgewählte Bereiche partiell beschichtet werden können. Hierdurch ist es möglich, nur partielle Beschichtungen zu erzeugen oder aber besonders belastete Strukturen von Substraten mit einer dickeren Schicht zu versehen.

Die Erfindung wird weiter anhand der nachfolgenden Ausführungsbeispiele beschrieben.

### Beispiel 1 - Abgaskrümmer:

Auf einen mit 15-25 µm galvanisch vernickelten Eisengusswerkstoff (z. B. niedriglegiertes Gusseisen mit Ni-Anteil < 1 %) wird eine 15-30 µm starke Rein-Aluminiumschicht über ein MOCVD-Verfahren aufgebracht, anschließend wird das Probenstück verbaut und einer Prozess- bzw. Betriebstemperatur von 400-900°C für 0,5 bis 8 Stunden ausgesetzt. Maßgebend ist hierbei jeweils die Oberflächentemperatur des Bauteils. Durch die vorhandene Prozesstemperatur und entsprechende Expositionszeit bildet sich die stabile und durch die Al₂O₃-Auflage schützende Aluminiumlegierungsauflageschicht.

### Beispiel 2 - Abgaskrümmer:

Auf einen mit 0-15 µm galvanisch vernickelten Eisengusswerkstoff (z. B. mittellegiertem Gusseisen (Ni-Anteil ≤ 20%) oder hochlegiertem Gusseisen (Ni-Anteil > 20%) wird eine 15-30 µm starke Rein-Aluminiumschicht über ein MOCVD-Verfahren aufgebracht, anschließend wird das Probenstück verbaut und einer Prozess- bzw. Betriebstemperatur von 400-1050°C für 0,01 bis 8 Stunden ausgesetzt. Durch die vorhandene Prozesstemperatur und entsprechende Expositionszeit bildet sich die stabile und durch die Al₂O₃-Auflage schützende Aluminiumlegierungsauflageschicht.

### Beispiel 3 - Wärmetauscher:

Auf einen niedriglegierten Stahl (z.B. 10CrMo9-10 od. 16Mo3 od. 13CrMo4-4) wird eine 15-25 µm Nickelschicht galvanisch aufgebracht. Nachfolgend wird in einem separaten Prozessschritt eine 15-30 µm starke Rein-Aluminiumschicht über ein MOCVD-Verfahren aufgebracht, anschließend wird das Probenstück verbaut und einer Prozess- bzw. Betriebstemperatur von 400-700°C für 0,25 bis 8 Stunden ausgesetzt.

### Beispiel 4 - Beschichtund heißer Oberflächen

Auf ein heißes Substrat, das während seines Herstellungs- bzw. Formgebungsprozesses eine Temperatur zwischen 700 - 1350° C aufweist, wird eine Beschichtung aufgebracht. Je nach eingesetztem Grundmaterial und Herstell- bzw. Formgebungsverfahren kann die Temperatur jedoch auch zwischen 700 - 1150 ° C liegen. Es wird eine metallische Schicht aus Aluminium aufgebracht, wobei aufgrund der Substrattemperatur sofort eine schützende Aluminiumschicht sowie die Legierungsschicht im Randbereich des Substrats ausgebildet wird. Anstelle einer Aluminiumschicht sind auch andere Beschichtungswerkstoffe sowie Mischpulver, beispielsweise der Elemente Ni, Cr, Ti u. a., zur Beschichtung möglich. Vor dem Aufbringen der metallischen Schicht muss je nach Ausgestaltung des Beschichtungsverfahrens für eine weitgehend zunderfreie Oberfläche, beispielsweise über Druckwasserentzunderung oder entsprechenden Schutzgaseinsatz, gesorgt werden.

Das Grundmaterial, welches das Substrat bildet, kann beispielsweise ein "Endlosprodukt" wie Rohr-, Band-, Draht- oder Stabmaterial sein, welches während seiner Formgebung die entsprechende Temperaturbeaufschlagung erfährt. Das Substrat wird direkt während seiner Formgebung durch Spritztechnik (thermisches Spritzen oder andere Metallpulverauftragsverfahren) beschichtet. Beispielsweise kann hierzu eine Beschichtungsanlage direkt in einer Walzstraße angeordnet sein, so dass die Beschichtung des Substrats kontinuierlich erfolgt.

Der Herstellprozess kann jedoch auch eine Temperaturbehandlung, beispielsweise ein Glühprozess (Spannungsarmglühen, o.ä.) sein. Die metallische Schicht wird nach dem Herstellprozess auf das noch heiße Substrat bzw. Bauteil aufgebracht, wobei die Beschichtung diskontinuierlich erfolgt. Die Erfindung ist nicht auf die genannten Ausführungsbeispiele beschränkt. Weitere Abwandlungen und Kombinationen im Rahmen der Patentansprüche fallen ebenfalls unter die Erfindung.

## Patentansprüche

1. Verfahren zur Beschichtung von im Betrieb oder beim Herstellungsprozess wärmebeaufschlagten Substraten oder Substraten mit vorhandener Kernwärme mit einer metallischen Oberfläche, bei welchem auf die metallische Oberfläche wenigstens eine metallische Schicht aufgebracht wird und bei welchem zwischen der Oberfläche und der wenigstens einen Schicht eine Legierungsschicht durch Interdiffusion erzeugt wird, **dadurch gekennzeichnet, dass** nach dem Aufbringen der wenigstens einen Schicht das Substrat an seinem Einsatzort montiert und in Betrieb genommen wird oder die wenigstens eine Schicht vor und/oder während und/oder nach dem Herstellprozess aufgebracht wird und dass die Legierungsschicht durch die Prozesswärme im Betrieb und/oder die Prozesswärme des Herstellprozesses erzeugt wird.

2. Verfahren nach dem vorhergehenden Anspruch, **dadurch gekennzeichnet, dass** die metallische Schicht nach dem Herstellungsprozess des Substrates auf die noch heiße Oberfläche des Substrates aufgebracht wird .

3. Verfahren nach einem der vorhergehenden Ansprüche, **dadurch gekennzeichnet, dass** die metallische Schicht während des Herstellungsprozesses des Substrates aufgebracht wird und die Legierungsschicht simultan erzeugt wird.

4. Verfahren nach einem der vorhergehenden Ansprüche, **dadurch gekennzeichnet, dass** die metallische Schicht in einem Durchlaufverfahren kontinuierlich oder diskontinuierlich auf das Substrat aufgebracht wird.

5. Verfahren nach einem der vorhergehenden Ansprüche, **dadurch gekennzeichnet, dass** die Legierungsschicht nach Montage des Bauteils während des/der ersten Einsatzes/Einsätze des Bauteiles zumindest teilweise, vorzugsweise zumindest nahezu vollständig, erzeugt wird.

6. Verfahren nach einem der vorhergehenden Ansprüche, **dadurch gekennzeichnet, dass** die Legierungsschicht zumindest teilweise bereits während des Beschichtungsvorganges erzeugt wird.

7. Verfahren nach einem der vorhergehenden Ansprüche, **dadurch gekennzeichnet, dass** eine metallische Schicht aus Al, Ti, Si, Ni, NiAl, Nickelverbindungen oder Cr aufgebracht wird.

8. Verfahren nach einem der vorhergehenden Ansprüche, **dadurch gekennzeichnet, dass** wenigstens eine Schicht in einem Niedertemperatur-MOCVD-Verfahren unter inerter Atmosphäre aufgebracht wird.

9. Verfahren nach einem der vorhergehenden Ansprüche, **dadurch gekennzeichnet, dass** eine reinmetallische Aluminiumschicht aufgebracht wird und als Legierungsschicht eine Aluminidschicht oder Aluminium-Nickelverbindung erzeugt wird.

10. Verfahren nach einem der vorhergehenden Ansprüche, **dadurch gekennzeichnet, dass** vor dem Aufbringen der metallischen Schicht eine Zwischenschicht, vorzugsweise eine homogene Nickelschicht oder Nickelverbindungen, als metallische Oberfläche des Bauteiles aufgebracht wird.

11. Verfahren nach einem der vorhergehenden Ansprüche, **dadurch gekennzeichnet, dass** die metallische Schicht direkt auf die Oberfläche des Substrats aufgebracht wird, wobei das Substrat aus einem Eisenwerkstoff, vorzugsweise einem Eisenwerkstoff mit einem hohen NickelGehalt, besteht.

12. Verfahren nach einem der vorhergehenden Ansprüche, **dadurch gekennzeichnet, dass** die wenigstens eine Schicht auf eine innere Oberfläche eines heißmedienführenden Bauteiles aufgebracht wird.

13. Verfahren nach einem der vorhergehenden Ansprüche, **dadurch gekennzeichnet, dass** zur Innenbeschichtung des Bauteiles ein Precursorgas ausschließlich direkt in den Innenraum des Bauteiles geleitet wird.

14. Verfahren nach einem der vorhergehenden Ansprüche, **dadurch gekennzeichnet, dass** die wenigstens eine Schicht auf eine innere und/oder äußere Oberfläche eines heißgasbeaufschlagten Bauteiles einer Brennkraftmaschine aufgebracht wird.

15. Verfahren nach einem der vorhergehenden Ansprüche, **dadurch gekennzeichnet, dass** das Substrat in einem Reaktor beschichtet wird, wobei zugleich eine Außenbeschichtung weiterer Substrate erfolgt.

16. Verfahren nach einem der vorhergehenden Ansprüche, **dadurch gekennzeichnet, dass** das Substrat partiell in ausgewählten Strukturen beschichtet wird.

17. Verfahren nach einem der vorhergehenden Ansprüche, **dadurch gekennzeichnet, dass** eine Einströmrichtung des Precursorgases auf ausgewählte Strukturen des Bauteiles eingestellt wird.

18. Heißgas- und/oder heißmedien- und/oder temperaturbeaufschlagtes und/oder atmosphärisch beaufschlagtes Substrat mit einer Beschichtung hergestellt nach einem Verfahren nach einem der Ansprüche 1-17.

19. Bauteil nach dem vorhergehenden Anspruch, **dadurch gekennzeichnet, dass** auf der metallischen Oberfläche eine Aluminiumschicht aufgebracht ist und eine Legierungsschicht aus Aluminiden zwischen der Oberfläche und der Aluminiumschicht angeordnet ist.

20. Bauteil nach einem der vorhergehenden Ansprüche, **dadurch gekennzeichnet, dass** die Aluminid-Schicht eine Schichtdicke von vorzugsweise 15-100 µm aufweist.

21. Substrat nach einem der vorhergehenden Ansprüche, **dadurch gekennzeichnet, dass** die metallische Oberfläche des Substrats durch eine Zwischenschicht, vorzugsweise eine homogene Nickelschicht oder Nickelverbindungen, gebildet ist.

22. Substrat nach einem der vorhergehenden Ansprüche, **dadurch gekennzeichnet, dass** das Substrat aus einem Eisenwerkstoff, vorzugsweise einem Gusseisenwerkstoff, besteht.

23. Substrat nach einem der vorhergehenden Ansprüche, **dadurch gekennzeichnet, dass** das Substrat aus einem Werkstoff mit einem hohen Nickel-Gehalt von vorzugsweise über 10%, besonders bevorzugt über 20%, besteht.

24. Substrat nach einem der vorhergehenden Ansprüche, **dadurch gekennzeichnet, dass** das Substrat ein Endlosmaterial, insbesondere ein Strangpresserzeugnis oder ein Walzmaterial, ist.

25. Substrat nach einem der vorhergehenden Ansprüche, **dadurch gekennzeichnet, dass** die Legierungsschicht resistent gegenüber Angriff durch Sauerstoff, Schwefelverbindungen, Chlorverbindungen und Ammoniak bzw. aggressiven Stickstoffverbindungen oder deren jeweilige Zersetzungsprodukte und gegen Metal dusting ist.
